# EUROPEAN PATENT APPLICATION

(11) **EP 4 742 361 A1**
(43) Date of publication of application: **13.05.2026**
(21) Application number: 25214113.0
(22) Date of filing: 06.11.2025
(51) Int. Cl.: H01M 10/42, G01R 31/367, G01R 31/389

(54) **BATTERY AUTHENTICATION USING ELECTROCHEMICAL IMPEDANCE SPECTROSCOPY**

(30) Priority: 08.11.2024 US 202418942208
(71) Applicant: Microsoft Technology Licensing, LLC, Redmond, WA 98052-6399 (US)
(72) Inventor: Thirugnanam, Seran, Redmond, 98052-6399 (US); Owen, Craig Daniel, Redmond, 98052-6399 (US)
(74) Representative: Murgitroyd & Company

(57) **Abstract**

A method for battery authentication includes, at a battery controller of a battery subsystem, measuring a test electrochemical impedance spectroscopy (EIS) response of one or more battery cells connected to the battery controller. The test EIS response is compared to a historical EIS response stored in a storage subsystem, wherein the historical EIS response corresponds to one or more authentic battery cells associated with the battery controller. Based at least in part on a measured similarity between the test EIS response and the historical EIS response, the battery controller outputs an authenticity determination for the one or more battery cells connected to the battery controller.

## Description

### BACKGROUND

Many electronic devices include internal battery packs, which are used to provide electrical power to components of the electronic device. Battery packs used in electronic devices often include internal logic hardware configured to manage the battery's performance. For instance, battery controllers may be used to manage charging and discharging processes, ensure the safety of the battery pack, and prolong the lifespan of the battery pack by preventing conditions that could lead to degradation or failure.

### SUMMARY

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter. Furthermore, the claimed subject matter is not limited to implementations that solve any or all disadvantages noted in any part of this disclosure.

A method for battery authentication includes, at a battery controller of a battery subsystem, measuring a test electrochemical impedance spectroscopy (EIS) response of one or more battery cells connected to the battery controller. The test EIS response is compared to a historical EIS response stored in a storage subsystem, wherein the historical EIS response corresponds to one or more authentic battery cells associated with the battery controller. Based at least in part on a difference between the test EIS response and the historical EIS response, the battery controller outputs an authenticity determination for the one or more battery cells connected to the battery controller.

### BRIEF DESCRIPTION OF THE DRAWINGS

FIG. 1 schematically shows an example electronic device including a battery subsystem.
FIG. 2 illustrates an example method for battery authentication.
FIGS. 3A-3C schematically illustrate battery authentication operations based at least in part on the electrochemical impedance spectroscopy (EIS) response of battery cells.
FIG. 4 illustrates an example battery authentication process including preliminary and supplementary authentication checks.
FIG. 5 schematically shows an example computing system.

### DETAILED DESCRIPTION

Many electronic devices include internal battery subsystems, which use one or more battery cells to store electrical energy. The energy stored in the battery cells is used to provide power to hardware components of the electronic device. The performance of the battery cells may be managed by a battery controller integrated into the battery subsystem. For instance, the battery controller may regulate charging voltage and/or current for the battery cells, monitor the state-of-charge and state-of-health for the battery cells, perform cell balancing, perform thermal management, store logging data, etc.

In some cases, the original battery cells included in the battery subsystem may be replaced. This may be done, for instance, if the performance of the battery cells is negatively impacted by age and/or damage. However, battery cell replacement can lead to significant performance and safety concerns if the replacement battery cells are not authentic. Counterfeit or substandard battery cells can pose significant safety risks, including thermal runaway, reduced capacity, and shortened lifespan. Furthermore, replacement battery cells may in some cases be difficult to detect at the battery controller. This can cause the battery controller to apply configuration changes to the battery cells with the expectation that they will perform nominally, when in fact the battery cells may be counterfeit or otherwise defective, and thus perform in unstable and unpredictable ways.

Accordingly, the present disclosure is directed to techniques for authenticating the hardware components in a battery subsystem. The present disclosure primarily focuses on scenarios where the battery cells of the battery subsystem are authenticated. However, it will be understood that the techniques described herein may be used to detect changes or modifications to any electronic circuitry and components of the battery subsystem. This may include the battery cells, the battery pack protection systems, the controller circuit board, the entire battery subsystem as a whole, etc.

Specifically, the battery cells (and/or other components of the battery subsystem) are authenticated using electrochemical impedance spectroscopy (EIS), which is a technique that measures the impedance response of a battery component when stimulated by voltage or current waveforms over a range of frequencies. The impedance of a battery cell provides information about its internal electrochemical properties, including (but not limited to) charge transfer resistance, double-layer capacitance, diffusion characteristics, etc. Since these properties are inherently linked to the chemical composition, construction, and structural integrity of the battery cell, EIS can be used to distinguish between authentic and counterfeit cells based at least in part on their electrochemical signature, referred to herein as an "EIS response." According to the present disclosure, the battery controller measures the EIS response of one or more battery cells connected to the battery controller in the battery subsystem (referred to as a "test" EIS response). This is compared to a historical EIS response previously measured for the original battery cells of the battery subsystem, known to be authentic. Based at least in part on the results of this comparison, the battery controller outputs an authenticity determination, indicating whether the test EIS response and the historical EIS response are consistent with one another. It will be understood that similar operations may be performed to authenticate additional or alternative components of the battery subsystem besides the battery cells, depending on where the EIS signal is injected and which frequencies are used.

In other words, by integrating EIS response measurement into the battery controller, it is possible to conduct in-situ or real-time impedance measurements on the battery cells (and/or other components) connected to the controller. Additionally, or alternatively, components of the battery subsystem may be tested using EIS when the battery is not inside the electronic device - e.g., using an external testing station. In any case, the impedance measurements obtained through EIS testing can be analyzed to identify characteristic patterns associated with genuine battery components, allowing the system to detect deviations that may indicate the presence of counterfeit or substandard components. Furthermore, EIS-based authentication can be performed without disrupting the normal operation of the battery, making it a non-intrusive and efficient method for ongoing monitoring. In this manner, the techniques discussed herein can beneficially improve the reliability and performance of the electronic device. For instance, authenticating battery cells during operation can help prevent the use of non-compliant or faulty cells, thereby enhancing the safety and reliability of the battery pack. Furthermore, the techniques discussed herein may enable detection of inauthentic battery cells consistently and with minimal impact to system performance, which can improve the lifespan of the electronic device.

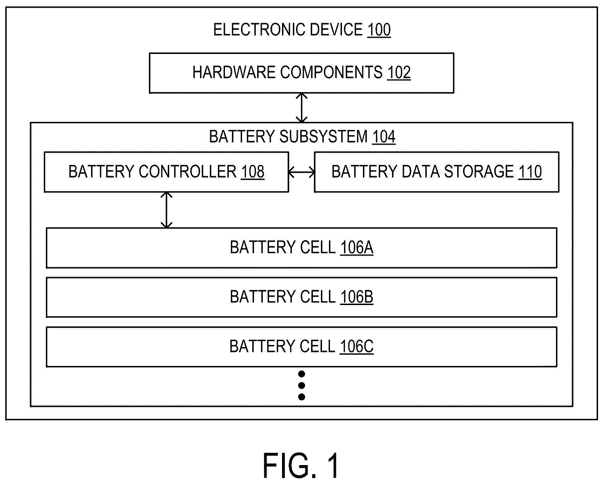

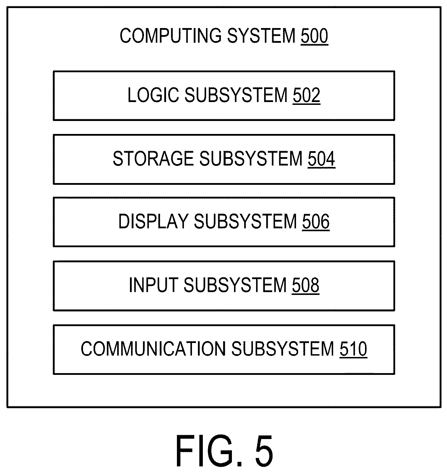

FIG. 1 schematically shows an example electronic device 100. The electronic device may have any suitable capabilities, hardware configuration, and form factor. As non-limiting examples, the electronic device may be a laptop computer, smartphone, drone, vehicle (e.g., autonomous car, e-bike, scooter), power tool, smartwatch, display device (e.g., head-mounted display), sensor device, input device, and/or any other suitable electronic device that includes an integrated battery. In some examples, electronic device 100 may be implemented as computing system 500 described below with respect to FIG. 5.

The electronic device includes one or more hardware components 102. The hardware components refer to any of a wide variety of suitable types of device components that may draw electrical power during use. These can include, for instance, logic components (e.g., processors), storage components (e.g., memory, non-volatile storage devices), display devices, input devices, communication interfaces (e.g., wireless communication antennas and receivers), sensors, output devices (e.g., indicator lights, audio speakers), electronic mechanisms (e.g., switches, actuators, solenoids), etc. As non-limiting examples, hardware components 102 may include any or all of the logic subsystem 502, storage subsystem 504, display subsystem 506, input subsystem 508, and communication subsystem 510 described below with respect to FIG. 5. In general, the techniques described herein focus on authentication of battery cells by a battery controller within a battery subsystem, and the present disclosure is agnostic as to the type of electronic device that the battery subsystem is used to power. Furthermore, in some cases, EIS testing may be performed by a separate testing station connected to the battery subsystem when the battery subsystem is not inside the electronic device. In other words, the EIS testing may be performed and analyzed by components other than the battery controller located inside of the battery subsystem.

The hardware components are powered by a battery subsystem 104, which includes a plurality of battery cells 106. In the example of FIG. 1, the electronic device includes at least three battery cells 106A, 106B, and 106C. However, it will be understood that a "battery subsystem" as described herein may include any suitable number and variety of battery cells. Each battery cell may use any suitable underlying battery chemistry and physical configuration to store and discharge electrical power (e.g., lithium-ion, lead-acid, nickel-based, etc.). Each battery cell may have any suitable capacity, output current, output voltage, and other various electrochemical parameters.

While the present disclosure focuses on electronic devices that include internal battery subsystems, this does not require that the battery subsystem is the sole source of power for the electronic device. For instance, the electronic device may include one or more additional power supplies besides the battery subsystem - e.g., the device may be configured to draw power from an electrical outlet when plugged in, and operate on battery power when unplugged.

As discussed above, the battery subsystem includes a battery controller 108 configured to manage the performance of the battery cells. This can include, for instance, regulating the charging voltage and/or current for the battery cells, monitoring the state-of-charge and state-of-health for the battery cells, performing cell load balancing, performing thermal management, storing and maintaining logging data, etc. To this end, the battery controller is communicatively coupled with battery data storage subsystem 110 within battery subsystem 104. This may be used to store any suitable data related to the battery's history and/or performance. For instance, as will be described in more detail below, the battery data storage subsystem may be used to store a historical EIS response for the original battery cells associated with the battery controller, known to be authentic. In general, the battery controller and battery data storage subsystem may be implemented using any suitable computer data processing and storage hardware, such as logic subsystem 502 and storage subsystem 504 of FIG. 5. In some examples, the battery controller and battery data storage subsystem may be implemented together as a single component.

As discussed above, it is in some cases possible to replace the original battery cells included in a battery subsystem with replacement battery cells. While this can potentially be used to extend the lifespan of the device (e.g., in cases where age and/or damage have degraded the performance of the original battery cells), it can also create potential safety hazards when inauthentic or defective battery cells are installed. Furthermore, it can be difficult for the battery controller to detect hardware changes. Thus, the battery controller may apply configuration settings to substandard battery cells, which can potentially cause unstable conditions, safety hazards, and failure.

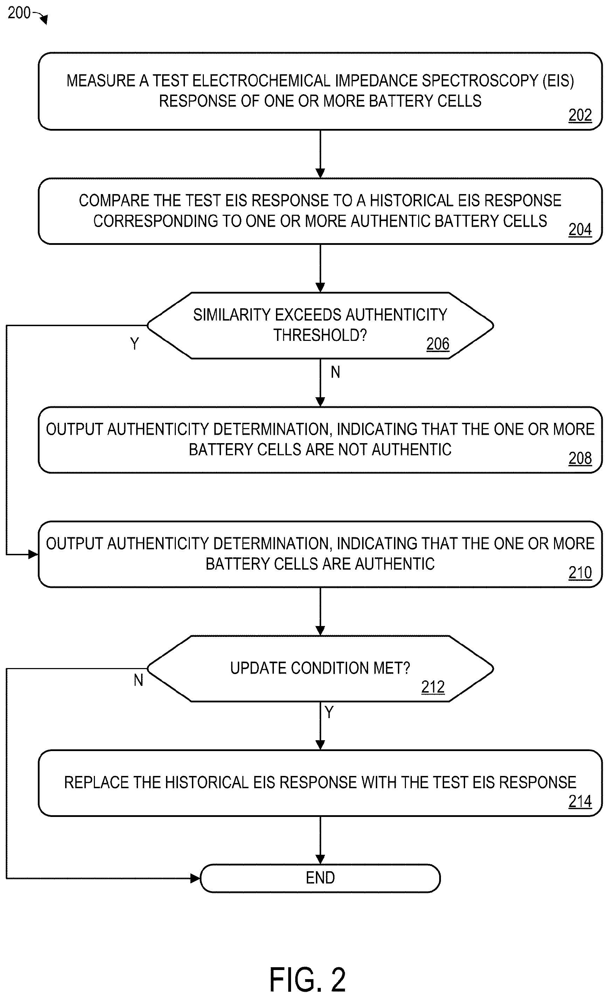

Accordingly, FIG. 2 illustrates an example method 200 for battery authentication. Steps of method 200 may be initiated, terminated, and/or repeated at any suitable time and in response to any suitable condition. Method 200 is primarily described as being performed by a battery controller of a battery subsystem. As discussed above, the battery controller may take the form of any suitable computer logic hardware, and the battery subsystem may be integrated into any suitable electronic device, having any suitable capabilities, form factor, and hardware configuration. Furthermore, in some cases, method 200 may be performed by a component other than the battery controller - e.g., an external testing station. In some examples, method 200 may be implemented with respect to computing system 500 of FIG. 5.

At 202, method 200 includes measuring a test electrochemical impedance spectroscopy (EIS) response of one or more battery cells connected to the battery controller. Note that these are not necessarily the same battery cells that were originally connected to the battery controller. Rather, at some point in the past, the battery cells may have been replaced - e.g., with inauthentic battery cells that do not perform as expected. Thus, method 200 aims to detect whether the battery cells currently connected to the battery controller are the same as the original, authentic battery cells for that battery controller. While the present disclosure primarily focuses on authentication of battery cells, it will be understood that similar techniques may be used to test the authenticity of additional or alternative components of the battery subsystem.

As discussed above, EIS is a technique used to study the electrical properties of materials and systems, particularly their impedance behavior over a range of frequencies. It involves applying pulse waves over a frequency range (e.g., a series of small alternating current (AC) or alternating voltage (AV) signal at several preselected frequencies) to a sample and measuring the resulting voltage or current response for each fundamental frequency of the applied pulse wave, referred to herein as an EIS response. When used by a battery controller to test the authenticity of one or more battery cells current connected to the battery controller, the present disclosure refers to the EIS response as a "test" EIS response. This is distinct from the historical EIS response stored in a storage subsystem, which is recorded for the original, authentic battery cells of the battery subsystem. EIS responses may be reported and formatted in any suitable way. In some scenarios, EIS responses may be presented as Nyquist or Bode plots, or as a distribution of relaxation times (DRT).

EIS is sensitive to changes in the electrochemical system, and thus can be used to provide detailed information about the electrochemical processes occurring within the battery. For instance, this may include measuring the responses of different features and processes in the battery pack using different time constants and accompanying EIS measurement frequency ranges. In this manner, various processes can be measured, such as the evolution of charge transfer resistance to identify electrolyte composition and anode/cathode material, the Ohmic resistance (e.g., the phase transition real impedance (PTRI)), and/or properties of battery pack components other than the battery cells (e.g., higher frequencies can be used to measure properties of the printed circuit module (PCM) on the battery pack to detect presence of a counterfeit or modified PCM).

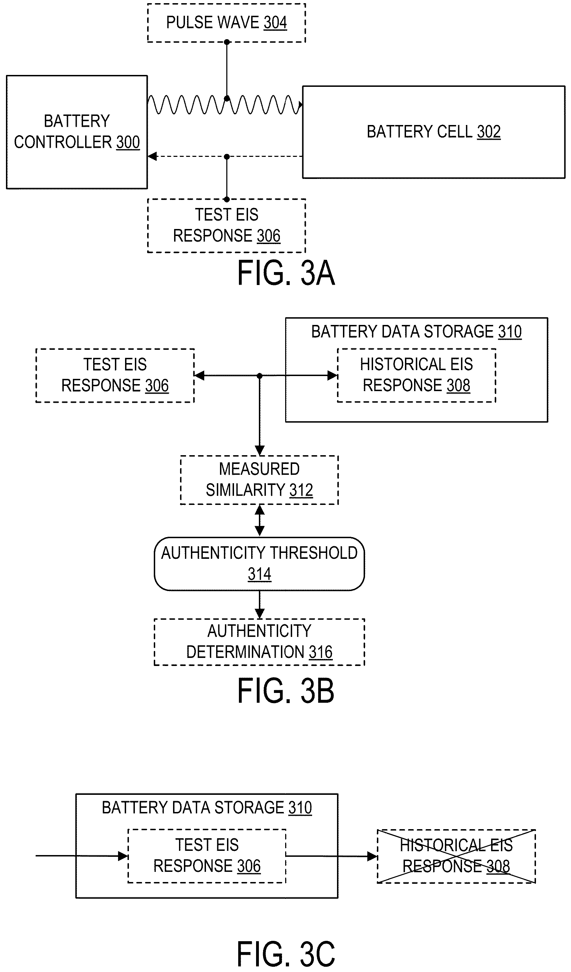

Measurement of the test EIS response of a set of battery cells is schematically illustrated with respect to FIG. 3A, showing another example battery controller 300 and battery cell 302 of a battery subsystem. The battery cell is connected to the battery controller within the battery subsystem, and the battery controller is attempting to determine whether the battery cell is the authentic battery cell associated with the battery controller, rather than a potentially faulty replacement. As shown, the battery controller inputs a pulse wave 304 to the battery cell 302. The voltage response of the battery cell is measured as a test EIS response 306 and received by the battery controller 300.

The test EIS response may be measured in any suitable way. In some examples, this includes supplying a pulse wave at one or more predetermined frequencies, and then measuring the resulting voltage response from the battery cells. For instance, the battery controller may provide a pulse wave at a first frequency, then sweep the pulse wave through a range of frequencies. In some cases, multiple pulse waves may be provided at multiple frequencies, for the same or different durations, and the battery controller may measure the electrical conditions at the one or more battery cells caused by the pulse waves. The frequencies may range between 0.1Hz to 30KHz, as non-limiting examples. In some cases, multiple frequencies may be provided in the same pulse wave, which is sometimes referred to as a "multisine." For instance, the same wave may carry a low frequency signal and a high frequency signal, and the controller may sweep the signals in opposite directions during measurement of the test EIS response.

In some cases, the predetermined frequencies at which the EIS response is measured may be selected based at least in part on a battery model of the original, authentic battery cells associated with the battery controller. Different types of batteries may exhibit different characteristics when their EIS responses are measured. For instance, lithium-ion batteries, lead-acid batteries, and nickel-based batteries may exhibit different responses at low, medium, and high frequency ranges due to differences in charge transfer resistance, ion diffusion processes, etc. As such, the specific frequencies measured by the battery controller may be determined at time of manufacture, based at least in part on the type of battery cells used. These frequencies may be selected because they correspond to traits of the EIS response that remain relatively stable over time (e.g., they are not significantly impacted by battery cell aging), and/or because they can be used to distinguish the battery cell from other types of battery cells that use different underlying battery chemistries. This beneficially enables authentication of battery cells over time, even as certain properties of the battery change due to aging.

In one example process, during the development phase, a full spectrum frequency sweep may be used to measure the spectra response of a set of battery cells, and identify a set of baseline features that can be used for authentication. Similar measurements may be performed on aged cells exhibiting degradation, providing insight into how different electrochemical features of the battery cells change over time. This may also be used to determine how different features should be weighted when comparing a test EIS response to a historical EIS response. Features selected for authentication may result from different individual frequencies, aggregates of frequencies, and/or mathematical summations/operations of the frequencies, and may therefore be specified and identified during the development phase of the battery pack. Selecting frequency ranges that capture more processes using the EIS measurement may beneficially result in more parameters that can be used for authentication.

Regardless, the battery controller measures the test EIS response of the battery cells to which it is connected. Because the EIS response may be affected by the current context and environment of the battery pack (e.g., charging/discharging state, charge level, temperature), then in some cases the test EIS response may be measured when the one or more battery cells have a predetermined charging state. For instance, the test EIS response may be measured when the electronic device is plugged in and fully charged, and at a time of day (such as the early morning) when the device is not in use. However, the test EIS response may additionally or alternatively be measured at other charging states, depending on the implementation. In some cases, test EIS responses may be measured at various different charging states (e.g., corresponding to different remaining charge percentages), and compared to historical EIS responses corresponding to each of those different charging states, stored in a lookup table or other suitable data structure.

Furthermore, the test EIS response may be measured with any suitable frequency, and/or in response to any suitable trigger. For instance, the test EIS response may be measured each time the device is fully charged, each time the device is power cycled, each time a predetermined time interval has elapsed (e.g., hour, day, week), etc.

Returning briefly to FIG. 2, at 204, method 200 includes comparing the test EIS response to a historical EIS response stored in a storage subsystem. The historical EIS response corresponds to one or more authentic battery cells associated with the battery controller. For instance, the EIS response of the battery cells may be recorded when the device is first manufactured, powered on, when the battery pack is first installed, and/or at any other suitable time, and stored in the storage subsystem as the historical EIS response. By comparing the test EIS response to this stored historical EIS response, the battery controller may determine whether the currently connected battery cells are consistent with the original, authentic battery cells for which the historical EIS response was recorded.

This process is schematically illustrated with respect to FIG. 3B, which illustrates comparison between the test EIS response 306 and a historical EIS response 308. The degree of similarity between these two datasets is quantified as measured similarity 312, which is used as the basis to determine whether the battery cells are authentic. In this example, the historical EIS response is stored by a data storage component that is specific to the battery subsystem, although it will be understood that this need not be the case. Rather, while the storage subsystem used to store the historical EIS response is communicatively coupled with the battery controller, such that the historical EIS response is accessible to the battery controller, this does not require that the storage subsystem is integrated into the battery subsystem. For instance, in some cases, the storage subsystem may refer to data storage hardware that is within the electronic device but independent from the battery subsystem, rather than an integrated storage subsystem of the battery.

The test EIS response and historical EIS response may be compared in any suitable way in order to determine the relative degree of difference or similarity between the two sets of data. In one non-limiting approach, this may include converting the test EIS response into a test result vector, converting the historical EIS response into a historical result vector, and computing a vector similarity between the test result vector and the historical result vector. Use of vectors in this manner can provide a relatively time and cost-efficient method of determining whether a current battery test result is consistent with a historical battery test result. More specifically, as one example, features of the historical EIS response may be arranged in a vector of size nx1, where n is the number of features extracted from the historical EIS response. Similarly, the features of the test EIS response may also be arranged in a vector of size nx1. These two vectors may then be aggregated to measure how similar they are. This can be done using any suitable aggregate and compare operation, based on any suitable mathematical or statistical technique, to measure the similarity of the two vectors (e.g., a weighted cosine similarity), and output a value quantifying this similarity (e.g., a value of between zero and one).

However, it will be understood that other suitable comparison processes may additionally or alternatively be used to compare the test and historical EIS responses, and the results of these comparison processes may be quantified in other suitable ways (e.g., having other suitable values and ranges). Regardless of the specific process used, the result of the comparison between the test EIS response and the historical EIS response may be compared to a threshold to determine whether the battery cells are authentic. To this end, returning briefly to FIG. 2, at 206, method 200 includes determining whether the measured similarity between the test EIS response and the historical EIS response exceeds an authenticity threshold. This is also illustrated with respect to FIG. 3B, in which the measured similarity 312 is compared to an authenticity threshold 314. The result of this comparison (i.e., whether or not the authenticity threshold is exceeded) is used to output an authenticity determination 316 for the one or more battery cells connected to the battery controller.

The authenticity threshold may have any suitable value, depending on the implementation (e.g., depending on the process used to compare the test and historical EIS vectors) and depending on desired degree of confidence. For instance, having a relatively high authenticity threshold may improve the chances of successfully detecting inauthentic battery cells. However, this can also result in more false positives. Furthermore, two battery cells with relatively similar EIS responses will likely exhibit similar performance. As such, a relatively lower authenticity threshold may in some cases be sufficient, as any counterfeit battery cell that has a similar EIS response to the original, authentic battery cell is likely to exhibit similar performance to the authentic battery cell, and thus is relatively less likely to pose safety risks. However, battery cells with significantly different EIS responses would beneficially still be detected if a lower authenticity threshold is used.

After this comparison, the battery controller outputs an authenticity determination, which indicates whether the battery cells were determined to be authentic. For instance, with respect to FIG. 2, if the measured similarity does not exceed the authenticity threshold, then the method proceeds to 208, which includes outputting an authenticity determination indicating that the one or more battery cells connected to the battery controller are not the one or more authentic battery cells. Alternatively, if the measured similarity does exceed the authenticity threshold, then the method proceeds to 210, which includes outputting an authenticity determination indicating that the one or more battery cells connected to the battery controller are the one or more authentic battery cells.

As discussed above, certain electrochemical features of a battery cell may change over time, as the battery ages. As such, it may in some cases be desirable to update the historical EIS response over time. Otherwise, an authentic battery cell could eventually be classified as inauthentic by the battery controller, due to gradual changes in the battery cell's EIS response. As such, at 212 of method 200, the method includes determining whether an update condition is met. If so, then at 214, the method includes replacing the historical EIS response stored in the storage subsystem, with the test EIS response. In this manner, the recently-measured test EIS response becomes the new historical EIS response, and may be used in the future for subsequent battery authentication. This is schematically illustrated with respect to FIG. 3C, in which the test EIS response 306 replaces the historical EIS response 308 in the battery data storage subsystem 310.

Any suitable update condition may be used as the trigger for updating the historical EIS response. In one example, after determining that the measured similarity between the test and historical EIS responses exceeds the authenticity threshold, then the measured similarity may be compared to a second, higher update threshold. If the measured similarity is higher than the update threshold, then the two EIS responses are still very similar, and the historical EIS response is not updated. However, if the measured similarity is higher than the authenticity threshold and lower than the update threshold, this may indicate that the EIS response of the authentic battery cell has changed over time. As such, the historical EIS response may be replaced with the test EIS response.

Additionally, or alternatively, the historical EIS response may be updated based at least in part on a predetermined update interval elapsing. This may, for instance, refer to an amount of total time passing (e.g., days, weeks, months), and/or an amount of battery charge cycles being detected. If a test EIS response is recorded that indicates the battery cells are authentic, and the predetermined update interval has elapsed, then the historical EIS response may be replaced with the test EIS response. This can beneficially improve the accuracy with which the battery cells are authenticated, as the historical EIS response is updated over time as properties of the battery change.

In some examples, device performance and efficiency may be improved by dividing the authentication process into preliminary and supplementary authentication checks, in which different electrochemical features of the battery cells are measured and compared to historical counterparts. If the preliminary authentication check indicates that the battery cells are likely authentic, then the supplementary authentication check may in some cases be bypassed, which can save time, electrical power, and processing resources of the electronic device. However, if the preliminary authentication check indicates that the battery cells are potentially inauthentic, then a relatively more intensive supplementary authentication check can be used to confirm this determination. This can beneficially correct for any false classification output by the preliminary authentic check - e.g., the supplementary check can correct a false positive output by the preliminary authentication check.

To this end, it may be beneficial for the preliminary authentication check to evaluate relatively characteristic and representative electrochemical features of the battery cells. As one non-limiting example, for certain battery configurations, this may include the phase-transition real impedance (PTRI) of the battery cells, which can serve as a useful harbinger of battery authenticity. This is because it is believed that the PTRI of a set of battery cells may be relatively static over time, and relatively characteristic for a given battery cell configuration, as compared to other battery cell configurations. PTRI refers to the real part of the impedance (the resistive component) in a system undergoing a phase transition. In the context of EIS, impedance is generally represented as a complex quantity consisting of both a real part (representing resistance) and an imaginary part (representing reactance). A phase transition in a material (such as from a solid to liquid state, or a crystalline to amorphous phase) can significantly affect its electrical properties. During a phase transition, changes in atomic or molecular structure may alter how charge carriers move through the material. This, in turn, affects the real impedance (resistance), as well as the imaginary component (reactance) in frequency-dependent measurements. In practical terms, when a phase transition occurs, the real impedance can either increase or decrease depending on the material's conductivity changes during the transition, and this behavior can be used to evaluate the battery's authenticity.

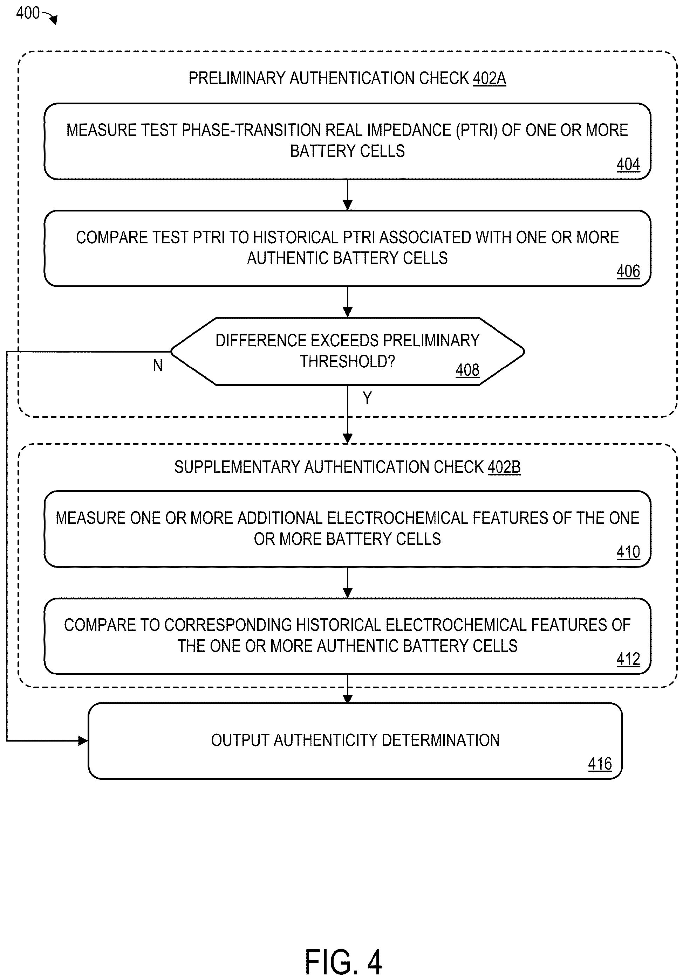

To this end, FIG. 4 illustrates an example method 400 for battery authentication, which includes preliminary and supplementary authentication checks. As with method 200, steps of method 400 may be initiated, terminated, and/or repeated at any suitable time and in response to any suitable condition. Furthermore, method 400 may be performed by any suitable computing device, having any suitable capabilities, hardware configuration, and form factor. As one example method 400 may be implemented by computing system 500 described below with respect to FIG. 5.

At 402, method 400 begins in a preliminary authentication check 402A. Within the preliminary authentication check, at 404, the method includes measuring the test PTRI of the one or more battery cells connected to the battery controller. At 406, the test PTRI is compared to a historical PTRI associated with the original, authentic battery cells for the battery controller. The test and historical PTRI may be measured and compared substantially as discussed above with respect to FIGS. 2 and 3A-3C. At 408, the method includes determining whether the difference between the test and historical PTRIs exceeds a preliminary threshold. If not, the system outputs an authenticity determination at 416, indicating that the battery cells are likely authentic.

However, if the difference between the test and historical PRTIs does exceed the preliminary threshold, then method 400 proceeds to a supplementary authentication check 402B. At 410, within the supplementary authentication check, the method includes measuring one or more additional electrochemical features of the one or more battery cells connected to the battery controller. These may include any or all of the electrochemical features described above that may be detected using EIS. In other words, in the supplementary authentication check, the system records a test EIS response for the battery cells as discussed above. At 412, the test EIS response is compared to corresponding historical electrochemical features (e.g., a historical EIS response) to determine whether the supplementary authentication check is consistent with authenticity of the battery cells. If so, then at 416, the authenticity determination may indicate that the battery cells are authentic, in spite of the earlier preliminary result. Alternatively, if the supplementary authentication check is not consistent with authenticity of the battery cells, then at 416 the authenticity determination may indicate that the battery cells are not authentic.

The methods and processes described herein may be tied to a computing system of one or more computing devices. In particular, such methods and processes may be implemented as an executable computer-application program, a network-accessible computing service, an application-programming interface (API), a library, or a combination of the above and/or other compute resources.

FIG. 5 schematically shows a simplified representation of a computing system 500 configured to provide any to all of the compute functionality described herein. Computing system 500 may take the form of one or more personal computers, network-accessible server computers, tablet computers, home-entertainment computers, gaming devices, mobile computing devices, mobile communication devices (e.g., smart phone), virtual/augmented/mixed reality computing devices, wearable computing devices, Internet of Things (IoT) devices, embedded computing devices, and/or other computing devices.

Computing system 500 includes a logic subsystem 502 and a storage subsystem 504. Computing system 500 may optionally include a display subsystem 506, input subsystem 508, communication subsystem 510, and/or other subsystems not shown in FIG. 5.

Logic subsystem 502 includes one or more physical devices configured to execute instructions. For example, the logic subsystem may be configured to execute instructions that are part of one or more applications, services, or other logical constructs. The logic subsystem may include one or more hardware processors configured to execute software instructions. Additionally, or alternatively, the logic subsystem may include one or more hardware or firmware devices configured to execute hardware or firmware instructions. Processors of the logic subsystem may be single-core or multi-core, and the instructions executed thereon may be configured for sequential, parallel, and/or distributed processing. Individual components of the logic subsystem optionally may be distributed among two or more separate devices, which may be remotely located and/or configured for coordinated processing. Aspects of the logic subsystem may be virtualized and executed by remotely-accessible, networked computing devices configured in a cloud-computing configuration.

Storage subsystem 504 includes one or more physical devices configured to temporarily and/or permanently hold computer information such as data and instructions executable by the logic subsystem. When the storage subsystem includes two or more devices, the devices may be collocated and/or remotely located. Storage subsystem 504 may include volatile, nonvolatile, dynamic, static, read/write, read-only, random-access, sequential-access, location-addressable, file-addressable, and/or content-addressable devices. Storage subsystem 504 may include removable and/or built-in devices. When the logic subsystem executes instructions, the state of storage subsystem 504 may be transformed - e.g., to hold different data.

Aspects of logic subsystem 502 and storage subsystem 504 may be integrated together into one or more hardware-logic components. Such hardware-logic components may include program- and application-specific integrated circuits (PASIC / ASICs), program- and application-specific standard products (PSSP / ASSPs), system-on-a-chip (SOC), and complex programmable logic devices (CPLDs), for example.

The logic subsystem and the storage subsystem may cooperate to instantiate one or more logic machines. As used herein, the term "machine" is used to collectively refer to the combination of hardware, firmware, software, instructions, and/or any other components cooperating to provide computer functionality. In other words, "machines" are never abstract ideas and always have a tangible form. A machine may be instantiated by a single computing device, or a machine may include two or more sub-components instantiated by two or more different computing devices. In some implementations a machine includes a local component (e.g., software application executed by a computer processor) cooperating with a remote component (e.g., cloud computing service provided by a network of server computers). The software and/or other instructions that give a particular machine its functionality may optionally be saved as one or more unexecuted modules on one or more suitable storage devices.

When included, display subsystem 506 may be used to present a visual representation of data held by storage subsystem 504. This visual representation may take the form of a graphical user interface (GUI). Display subsystem 506 may include one or more display devices utilizing virtually any type of technology. In some implementations, display subsystem may include one or more virtual-, augmented-, or mixed reality displays.

When included, input subsystem 508 may comprise or interface with one or more input devices. An input device may include a sensor device or a user input device. Examples of user input devices include a keyboard, mouse, touch screen, or game controller. In some embodiments, the input subsystem may comprise or interface with selected natural user input (NUI) componentry. Such componentry may be integrated or peripheral, and the transduction and/or processing of input actions may be handled on- or off-board. Example NUI componentry may include a microphone for speech and/or voice recognition; an infrared, color, stereoscopic, and/or depth camera for machine vision and/or gesture recognition; a head tracker, eye tracker, accelerometer, and/or gyroscope for motion detection and/or intent recognition.

When included, communication subsystem 510 may be configured to communicatively couple computing system 500 with one or more other computing devices. Communication subsystem 510 may include wired and/or wireless communication devices compatible with one or more different communication protocols. The communication subsystem may be configured for communication via personal-, local- and/or wide-area networks.

This disclosure is presented by way of example and with reference to the associated drawing figures. Components, process steps, and other elements that may be substantially the same in one or more of the figures are identified coordinately and are described with minimal repetition. It will be noted, however, that elements identified coordinately may also differ to some degree. It will be further noted that some figures may be schematic and not drawn to scale. The various drawing scales, aspect ratios, and numbers of components shown in the figures may be purposely distorted to make certain features or relationships easier to see.

In an example, a method for battery authentication comprises: at a battery controller of a battery subsystem, measuring a test electrochemical impedance spectroscopy (EIS) response of one or more battery cells connected to the battery controller; comparing the test EIS response to a historical EIS response stored in a storage subsystem, wherein the historical EIS response corresponds to one or more authentic battery cells associated with the battery controller; and based at least in part on a measured similarity between the test EIS response and the historical EIS response, output an authenticity determination for the one or more battery cells connected to the battery controller. In this example or any other example, the test EIS response is measured at one or more predetermined frequencies. In this example or any other example, measuring the test EIS response includes supplying one or more electrical pulse waves at the one or more predetermined frequencies to the one or more battery cells, and measuring electrical conditions at the one or more battery cells caused by the pulse waves. In this example or any other example, the one or more predetermined frequencies are selected based at least in part on a battery model of the one or more authentic battery cells. In this example or any other example, measuring the test EIS response includes measuring a test phase-transition real impedance (PTRI) of the one or more battery cells connected to the battery controller, and wherein the test PTRI is compared to a historical PTRI of the one or more authentic battery cells. In this example or any other example, the test PTRI is compared to the historical PTRI in a preliminary authenticity check, and wherein the method further comprises, responsive to the test PTRI differing from the historical PTRI by more than a preliminary threshold, performing a supplementary authenticity check in which one or more additional electrochemical features of the one or more battery cells connected to the battery controller are measured. In this example or any other example, comparing the test EIS response to the historical EIS response includes converting the test EIS response into a test result vector, converting the historical EIS response into a historical result vector, and wherein the measured similarity is a computed a vector similarity between the test result vector and the historical result vector. In this example or any other example, based at least in part on the measured similarity between the test EIS response and the historical EIS response being less than an authenticity threshold, the authenticity determination indicates that the one or more battery cells connected to the battery controller are not the one or more authentic battery cells. In this example or any other example, based at least in part on the measured similarity between the test EIS response and the historical EIS response being greater than an authenticity threshold, the authenticity determination indicates that the one or more battery cells connected to the battery controller are the one or more authentic battery cells. In this example or any other example, based at least in part on the measured similarity between the test EIS response and the historical EIS response being greater than the authenticity threshold and satisfying an update condition, the historical EIS response stored in the storage subsystem is replaced with the test EIS response. In this example or any other example, the method further comprises, based at least in part on a predetermined update interval elapsing, and based at least in part on the authenticity determination indicating that the one or more battery cells connected to the battery controller are the one or more authentic battery cells, replacing the historical EIS response stored in the storage subsystem with the test EIS response. In this example or any other example, the test EIS response is measured when the one or more battery cells connected to the battery controller have a predetermined charging state.

In an example, a battery subsystem comprises: one or more battery cells configured to store electrical energy; and a battery controller connected to the one or more battery cells, the battery controller configured to: measure a test electrochemical impedance spectroscopy (EIS) response of the one or more battery cells connected to the battery controller; compare the test EIS response to a historical EIS response stored in a storage subsystem, wherein the historical EIS response corresponds to one or more authentic battery cells associated with the battery controller; and based at least in part on a measured similarity between the test EIS response and the historical EIS response, output an authenticity determination for the one or more battery cells connected to the battery controller. In this example or any other example, the test EIS response is measured at one or more predetermined frequencies, and wherein measuring the test EIS response includes supplying one or more electrical pulse waves at the one or more predetermined frequencies to the one or more battery cells. In this example or any other example, measuring the test EIS response includes measuring a test phase-transition real impedance (PTRI) of the one or more battery cells connected to the battery controller, and wherein the test PTRI is compared to a historical PTRI of the one or more authentic battery cells. In this example or any other example, based at least in part on the measured similarity between the test EIS response and the historical EIS response being less than an authenticity threshold, the authenticity determination indicates that the one or more battery cells connected to the battery controller are not the one or more authentic battery cells. In this example or any other example, based at least in part on the measured similarity between the test EIS response and the historical EIS response being greater than an authenticity threshold, the authenticity determination indicates that the one or more battery cells connected to the battery controller are the one or more authentic battery cells. In this example or any other example, based at least in part on the measured similarity between the test EIS response and the historical EIS response being greater than the authenticity threshold and satisfying an update condition, the historical EIS response stored in the storage subsystem is replaced with the test EIS response. In this example or any other example, the test EIS response is measured when the one or more battery cells connected to the battery controller have a predetermined charging state.

In an example, an electronic device comprises: a battery subsystem including a battery controller and one or more battery cells configured to supply electrical power to components of the electronic device, wherein the battery controller is configured to: measure a test electrochemical impedance spectroscopy (EIS) response of the one or more battery cells connected to the battery controller; compare the test EIS response to a historical EIS response stored in a storage subsystem, wherein the historical EIS response corresponds to one or more authentic battery cells associated with the battery controller; based at least in part on a measured similarity between the test EIS response and the historical EIS response being greater than an authenticity threshold, output an authenticity determination for the one or more battery cells connected to the battery controller, the authenticity determination indicating that the one or more battery cells connected to the battery controller are the one or more authentic battery cells; and based at least in part on the measured similarity between the test ESI response and the historical EIS satisfying an update condition, replacing the historical EIS response with the test EIS response.

It will be understood that the configurations and/or approaches described herein are exemplary in nature, and that these specific embodiments or examples are not to be considered in a limiting sense, because numerous variations are possible. The specific routines or methods described herein may represent one or more of any number of processing strategies. As such, various acts illustrated and/or described may be performed in the sequence illustrated and/or described, in other sequences, in parallel, or omitted. Likewise, the order of the above-described processes may be changed.

The subject matter of the present disclosure includes all novel and non-obvious combinations and sub-combinations of the various processes, systems and configurations, and other features, functions, acts, and/or properties disclosed herein, as well as any and all equivalents thereof.
This application claims priority from US 18/942208 filed 08 Nov 2024, the entire contents of which are herein incorporated by reference.

## Claims

1. A method for battery authentication, the method comprising:
at a battery controller of a battery subsystem, measuring a test electrochemical impedance spectroscopy (EIS) response of one or more battery cells connected to the battery controller;
comparing the test EIS response to a historical EIS response stored in a storage subsystem, wherein the historical EIS response corresponds to one or more authentic battery cells associated with the battery controller; and
based at least in part on a measured similarity between the test EIS response and the historical EIS response, output an authenticity determination for the one or more battery cells connected to the battery controller.

2. The method of claim 1, wherein the test EIS response is measured at one or more predetermined frequencies.

3. The method of claim 2, wherein measuring the test EIS response includes supplying one or more electrical pulse waves at the one or more predetermined frequencies to the one or more battery cells, and measuring electrical conditions at the one or more battery cells caused by the pulse waves, and optionally wherein the one or more predetermined frequencies are selected based at least in part on a battery model of the one or more authentic battery cells.

4. The method of claim 1, wherein measuring the test EIS response includes measuring a test phase-transition real impedance (PTRI) of the one or more battery cells connected to the battery controller, and wherein the test PTRI is compared to a historical PTRI of the one or more authentic battery cells.

5. The method of claim 4, wherein the test PTRI is compared to the historical PTRI in a preliminary authenticity check, and wherein the method further comprises, responsive to the test PTRI differing from the historical PTRI by more than a preliminary threshold, performing a supplementary authenticity check in which one or more additional electrochemical features of the one or more battery cells connected to the battery controller are measured.

6. The method of claim 1, wherein comparing the test EIS response to the historical EIS response includes converting the test EIS response into a test result vector, converting the historical EIS response into a historical result vector, and wherein the measured similarity is a computed a vector similarity between the test result vector and the historical result vector.

7. The method of claim 1, further comprising, based at least in part on a predetermined update interval elapsing, and based at least in part on the authenticity determination indicating that the one or more battery cells connected to the battery controller are the one or more authentic battery cells, replacing the historical EIS response stored in the storage subsystem with the test EIS response.

8. A battery subsystem, comprising:
one or more battery cells configured to store electrical energy; and
a battery controller connected to the one or more battery cells, the battery controller configured to:
measure a test electrochemical impedance spectroscopy (EIS) response of the one or more battery cells connected to the battery controller;
compare the test EIS response to a historical EIS response stored in a storage subsystem, wherein the historical EIS response corresponds to one or more authentic battery cells associated with the battery controller; and
based at least in part on a measured similarity between the test EIS response and the historical EIS response, output an authenticity determination for the one or more battery cells connected to the battery controller.

9. The battery subsystem of claim 8, wherein the test EIS response is measured at one or more predetermined frequencies, and wherein measuring the test EIS response includes supplying one or more electrical pulse waves at the one or more predetermined frequencies to the one or more battery cells.

10. The battery subsystem of claim 8, wherein measuring the test EIS response includes measuring a test phase-transition real impedance (PTRI) of the one or more battery cells connected to the battery controller, and wherein the test PTRI is compared to a historical PTRI of the one or more authentic battery cells.

11. The method of claim 1 or the battery subsystem of claim 8, wherein, based at least in part on the measured similarity between the test EIS response and the historical EIS response being less than an authenticity threshold, the authenticity determination indicates that the one or more battery cells connected to the battery controller are not the one or more authentic battery cells.

12. The method of claim 1 or the battery subsystem of claim 8, wherein, based at least in part on the measured similarity between the test EIS response and the historical EIS response being greater than an authenticity threshold, the authenticity determination indicates that the one or more battery cells connected to the battery controller are the one or more authentic battery cells.

13. The method of claim 12 or the battery subsystem of claim 12, wherein, based at least in part on the measured similarity between the test EIS response and the historical EIS response being greater than the authenticity threshold and satisfying an update condition, the historical EIS response stored in the storage subsystem is replaced with the test EIS response.

14. The method of claim 1 or battery subsystem of claim 8, wherein the test EIS response is measured when the one or more battery cells connected to the battery controller have a predetermined charging state.

15. An electronic device, comprising:
a battery subsystem including a battery controller and one or more battery cells configured to supply electrical power to components of the electronic device, wherein the battery controller is configured to:
measure a test electrochemical impedance spectroscopy (EIS) response of the one or more battery cells connected to the battery controller;
compare the test EIS response to a historical EIS response stored in a storage subsystem, wherein the historical EIS response corresponds to one or more authentic battery cells associated with the battery controller;
based at least in part on a measured similarity between the test EIS response and the historical EIS response being greater than an authenticity threshold, output an authenticity determination for the one or more battery cells connected to the battery controller, the authenticity determination indicating that the one or more battery cells connected to the battery controller are the one or more authentic battery cells; and
based at least in part on the measured similarity between the test ESI response and the historical EIS satisfying an update condition, replacing the historical EIS response with the test EIS response.
